## Europäisches Patentamt

## European Patent Office

## Office européen des brevets

(19)

(11) Veröffentlichungsnummer: **0 073 942**

**B1**

(12)

# EUROPÄISCHE PATENTSCHRIFT

(45) Veröffentlichungstag der Patentschrift:
**10.06.87**

(51) Int. Cl.⁴: **H 01 L 21/82,** H 01 L 21/265

(21) Anmeldenummer: **82107240.2**

(22) Anmeldetag: **10.08.82**

(54) **Verfahren zum Herstellen von hochintegrierten komplementären MOS-Feldeffekttransistorschaltungen.**

(30) Priorität: **27.08.81 DE 3133841**

(43) Veröffentlichungstag der Anmeldung:
**16.03.83 Patentblatt 83/11**

(45) Bekanntmachung des Hinweises auf die Patenterteilung:
**10.06.87 Patentblatt 87/24**

(84) Benannte Vertragsstaaten:
**AT DE FR GB IT SE**

(56) Entgegenhaltungen:
**DE-A-2 740 549**
**US-A-3 920 481**
**US-A-4 027 380**
**US-A-4 151 635**
**US-A-4 280 272**

(73) Patentinhaber: **Siemens Aktiengesellschaft Berlin und München, Wittelsbacherplatz 2, D-8000 München 2 (DE)**

(72) Erfinder: **Schwabe, Ulrich, Dr., Grünwalderstrasse 40, D-8000 München 90 (DE)**
Erfinder: **Jacobs, Erwin, Dr., Stieglitzweg 9b, D-8011 Vaterstetten (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Patentanmeldung betrifft ein Verfahren zum Herstellen von hochintegrierten komplementären MOS-Feldeffekttransistorschaltungen (CMOS-Schaltungen), bei den für die Aufnahme der n- bzw. p-Kanal-Transistoren der Schaltung im Halbleitersubstrat p- bzw. n-dotierte Wannen erzeugt werden, in welche zur Einstellung der verschiedenen Transistoreinsatzspannungen die entsprechenden Dotierstoffatome durch mehrfache Ionenimplantationen eingebracht werden, wobei die Maskierung für die einzelnen Ionenimplantationen durch Fotolack- oder durch Siliziumoxid- bzw. Siliziumnitrid-Strukturen erfolgt und bei dem die Herstelung der Source/Drain- und Gate-Bereiche sowie die Erzeugung des Zwischen-Isolationsoxids und der Leiterbahnebene nach bekannten Verfahrensschritten der MOS-Technologie vorgenommen wird.

Die Aufgabe, die der vorliegenden Patentanmeldung zugrundeliegt, besteht in der Durchführung eines CMOS-Prozesses, bei dem möglichst wenig Prozeßschritte zur Herstellung der gewünschten Schaltung erforderlich sind, bei dem aber trotzdem gewährleistet wird, daß die Funktionsweise der Bauelemente der Schaltung dadurch nicht beeinträchtigt wird.

Bei den aus dem Stand der Technik bekannten Verfahren zur Herstellung von hochintegrierten komplementären MOS-Feldeffekttransistorschaltungen (CMOS-Schaltungen) werden zur Winstellung der verschiedenen Transistoreinsatzspannungen Mehrfachimplantationen nach verschiedenen Technologien verwendet, die sehr aufwendig sind.

So ist aus einem Aufsatz von L. C. Parillo et al "Twin-Tub CMOS - A Technology for VLSI Circuits" aus den Techn. Dig. IEDM 1980, 29.1., Seite 732-733 bekannt, die beiden n- bzw. p-dotierten Wannen in einem CMOS-Prozeß mittels selbstjustierender Prozeßschritte unter Verwendung nur einer Maske herzustellen. Der Nachteil der selbstjustierenden Implantation der beiden Wannen führt an der Implantationskante zu einer Kompensation der beiden n- bzw. p-implantierten Gebiete. Eine negative Folge davon ist, daß die Einsatzspannung des Dickoxidtransistors (im Feldoxidbereich) reduziert wird und die Stromverstärkung des lateralen parasitären pnp-Bipolartransistors, die zu einer vergrößerten "latch-up"-Wahrscheinlichkeit (das ist Zündwahrscheinlichkeit des parasitären Thyristors) führt, erhöht wird. Die Reduzierung der Dickoxideinsatzspannung wie "latch-up" führen zu einem Ausfall des Bauelements.

Ein anderes Verfahren, welches sowohl die beiden Wannen als auch die Kanal- und Feldinplantation unter Verwendung getrennter Masken durchführt, ist aus einem Aufsatz von Y. Sakai et al. "High Packing Density, High Speed CMOS (Hi-CMOS) Device Technology; aus dem Jap. J. Appl. Phys. 18, Suppl. 18-1, Seite 73-78, zu entnehmen. Der Nachteil dieses Verfahrens ist, daß, bedingt durch die Anzahl der benötigten Maskenschnitte der an und für sich schon in Bezug auf die Ausbeute kritische CMOS-Fertigungsprozeß sehr belastet wird.

Aus einem Aufsatz von De Witt Ong "An All-Implanted CCD/CMOS Process" aus dem IEEE Transact. Electr. Dev., Vol. ED-28 (1981) Seiten 6-12 ist es bekannt, als Dotierstoff für die n-dotierende Feldinplantation Phosphor zu verwenden. Diese Phosphorimplantation ergibt eine definierte laterale Ausdiffusion, die zu einer Erhöhung der parasitären Radkapazitäten an den Kanten der anschließenden Source/Drain-Gebiete führt. Dies wirkt sich durch eine Erhöhung der Schaltzeiten/Zugriffszeiten negativ auf die Schaltung aus.

Um alle diese Nachteile zu vermeiden, ist es ein wesentlicher Bestandteil der Erfindung, für die n-Wanne keine Extramaske einzusetzen und für die Feld- und Kanalimplantation der n-Kanal-Transistoren und der p-Kanal-Transistoren jeweils nur eine Maske zu verwenden.

Dies wird durch ein Verfahren der eingangs genannten Art erreicht, welches erfindungsgemäß durch den Ablauf folgender Verfahrensschritte gekennzeichnet ist:

a) Herstellung der p-Wanne durch eine Bor-Implantation im n-dotierten Substrat nach erfolgter Maskierung der übrigen Bereiche mit einer Oxidmaske,

b) Ablösen der Oxidmaskierung,

c) Herstellung der n-Wanne und Dotierung des p-Kanals durch eine ganzflächige Phosphor-, Arsen- oder Antimon-Implantation,

d) Abscheidung einer Siliziumnitridschicht in einer, der später zu erfolgenden Borimplantation angepaßten Schichtdicke und Strukturierung so, daß die Bereiche, in denen später die Kanaltransistoren erzeugt werden, von der Nitridschicht bedeckt bleiben,

e) Durchführung einer ersten Fotolacktechnik, wobei alle Bereiche außer den p-Warmenbereichen mit Fotolack bedeckt bleiben,

f) Durchführung einer doppelten Bor-Implantation, wobei zur Dotierung der Feldbereiche eine erste Bor-Implantation mit niedriger Energie durchgeführt wird, die von der Siliziumnitridschicht maskiert wird, und zur Dotierung des n-Kanals eine zweite Bor-Implantation mit höherer Energie durchgeführt wird, die von der Siliziumnitridschicht nicht maskiert wird,

g) Durchführung einer zweiten Fotolacktechnik nach Entfernen der ersten Fotolackstruktur, wobei alle Bereiche außer den n-Wannen-Bereichen mit Fotolack bedeckt bleiben,

h) Durchführung einer Arsen-Implantation zur Dotierung der Feldbereiche der p-Kanaltransistoren,

i) Ablösen der Fotolackstrukturen,

k) Erzeugen der Feldoxidbereiche mittels lokaler Oxidation unter Verwendung der

Siliziumnitridschicht als Maskierung und

I) Ablösen der Siliziumnitridmaske.

Es liegt im Rahmen der Erfindung, daß zum Schutz der Oberfläche vor der ganzflächigen n-Implantation zur Herstellung der n-Wanne und zur Dotierung des p-Kanals eine ganzflächige Oxidschicht auf der Substratoberfläche erzeugt wird.

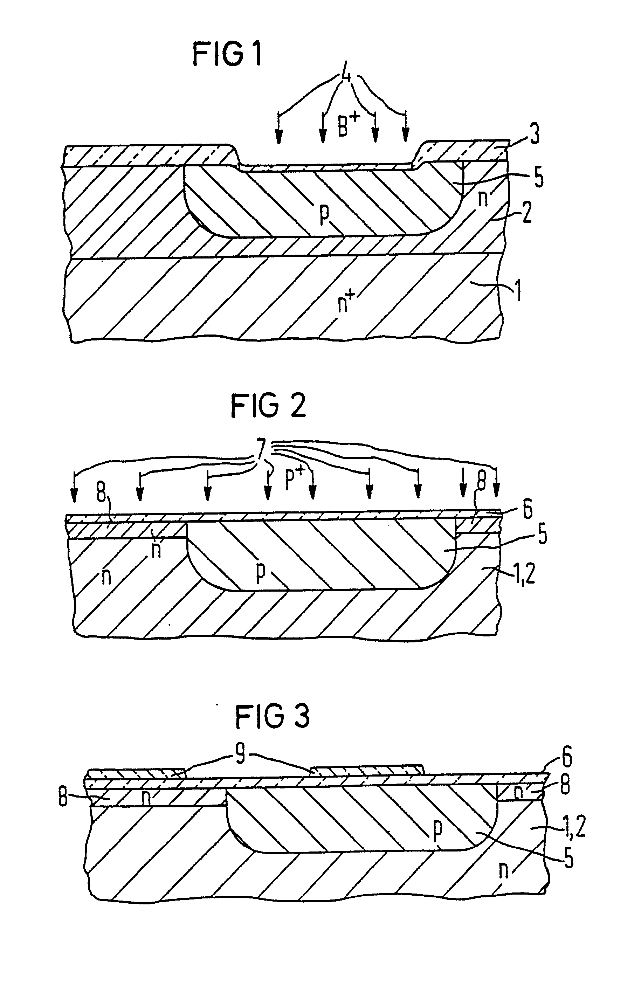

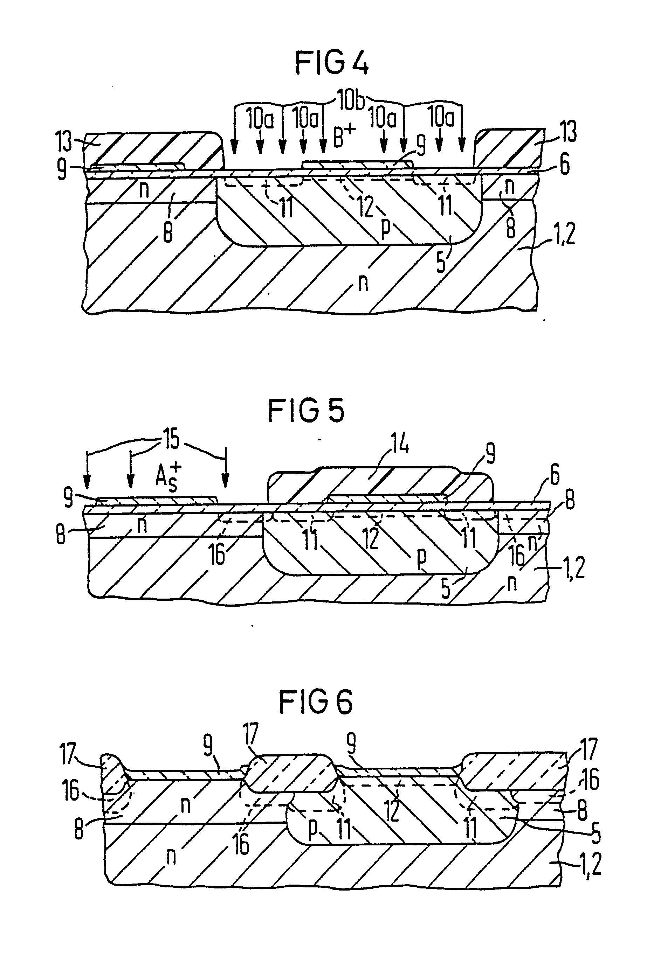

Weitere Ausgestaltungen der Erfindung ergeben sich aus den Unteransprüchen, sowie aus der Beschreibung eines Ausführugsbeispiels anhand der Figuren 1 bis 6, welche in Schnittbild die erfindungswesentlichen Verfahrensschritte darstellen.

Zu Beginn der Prozeßfolge wird die p-Wanne (5) hergestellt. Dabei wird von einen, mit einer $n^+$-dotierten Epischicht 2 (<100> -Si, 10 bis 50 $\Omega$ cm) versehenen n-dotierten Siliziumsubstrat 1 ausgegangen, welches mit einem, mit Hilfe einer Fotolacktechnik (nicht abgebildet) strukturierten Maskieroxid 3 von 700 nm Dicke versehen ist. Die Bor-Implantation 4 zur Erzeugung der p-Wanne 5 erfolgt mit einer Dosis und Energie im Bereich von $2 . 10^{12} - 1 . 10^{13}$ cm$^{-2}$ und 23 keV - 180 keV. Nach den Eintreiben der Dotierstoffatome für die p-Wanne 5 (6000 nm) entsteht die in Figur 1 gezeigte Anordnung.

**Figur 2:**

Die Oxidschicht 3 wird ganz entfernt und auf die Substratoberfläche (1, 2) eine Streuoxidschicht 6 in einer Schichtstärke von 50 nm aufgewachsen. Dann erfolgt eine ganzflächige Phosphor- oder Arsenimplantation 7 zur Erzeugung des p-Kanals und der n-Wanne 8.

Wie aus den Figuren 1 und 2 zu entnehmen ist, wird die Herstellung der beiden Wannen 5 und 8 mit nur einer Maske, jedoch unter Vermeidung des schaltungstechnisch nachteiligen, selbstjustierenden Schrittes (wie es bei dem Verfahren nach Parillo erfolgt) vorgenommen. Die n-Wanne 8 wird ohne eigenen Maskenschnitt durch die ganzflächige Phosphor- oder Arsen-Implantation 7 ($7 . 10^{10}$ bis $2 . 10^{11}$ cm$^{-2}$, 160 keV) mit anschließender Diffusion gebildet. Die Nachteile einer selbstjustierenden Wannenherstellung entfallen. Gleichzeitig wird mit der Phosphor- oder Arsen-Implantation 7 die Einsatzspannung der p-Kanal-Transistoren eingestellt. Dadurch ergibt sich die Einsparung eines Maskenschrittes. Ein weiterer großer Vorteil ist, daß die sonst übliche Kompensationsimplantation hohen Dosis in den Kanalbereich, die zu einer Verringerung der Durchbruchsspannungen (p-Kanal-Transistoren) führen würde, entfällt.

**Figur 3:**

Nach dem Eintreiben der Phosphor- bzw. Arsenatome für die n-Wanne 8 erfolgt dann die Siliziumnitridabscheidung in einer Schichtdicke von 120 nm und die Strukturierung der Siliziumnitridschicht 9 (Maske LOCOS).

**Figur 4**

Die Feld- und Kanalimplantation der n-Kanal-Transistoren wird mit einer Doppelimplantation 10a und 10b mit Bor durchgeführt, wobei neben einer Fotolackmaske, die alle Bereiche außer die zu implantierenden Wannenbereiche abdeckt, eine Siliziumnitridmaske 9 (LOCOS-Maske) verwendet wird und die Dicke dieser Maske so eingestellt wird, daß eine erste niederenergitische Bor-Implantation 10a ($1 . 10^{13}$ cm$^{-2}$, 25 keV) voll maskiert wird und nur die Feldbereiche 11 implantiert werden. Eine zweite Borimplantation 10b höherer Energie ($8 . 10^{11}$ cm$^{-2}$, 80 keV) kann die Siliziumnitridmaske 9 jedoch durchdringen und führt zu einer Implantation des Kanalbereiches 12. Die Dosen der beiden Bor-Implantationen 10a und 10b werden so bemessen, daß sowohl die Einsatzspannung der n-Kanal-Dünnoxid-Transistoren, als auch der Dickoxid-Transistoren (zweifach implantierter Feldbereich) definiert eingestellt werden können.

**Figur 5:**

Nach Entfernen der ersten Fotolackstruktur 13 wird eine zweite Fotolackstruktur 14 erzeugt, wobei alle Bereiche außer den n-Wannenbereichen 8 mit dem Fotolack 14 bedeckt werden. Nun erfolgt die Feldimplantationen (16) der p-Kanal-Transistoren mit einer Arsen-Implantation 15 (Dosis und Energie $5 . 10^{11} - 5 . 10^{13}$, 60 - 180 keV). Infolge des kleineren Diffusionskoeffizienten von Arsen im Vergleich zum üblicherweise verwendeten Phosphor (zum Beispiel bei dem Verfahren anch De Witt Ong) ist die laterale Ausdiffusion wesentlich schwächer. Die parasitären Kapazitäten an den Rändern der Source/Drain-Gebiete werden dadurch um 20 bis 30 % verringert, was zu einer Verbesserung der Schaltzeiten führt.

**Figur 6:**

Nach Ablösen der Fotolackstrukture 14 werden die Feldoxidbereiche 17 in einer Schichtdicke von 1000 nm mittels lokaler Oxidation unter Verwendung der Siliziumnitridmaske 9 erzeugt. Alle weiteren Prozeßschnitte können nach Entfernen der Nitridmaske 9 nach bekannten Verfahrensschritten der CMOS-Technologie erfolgen.


**Patentansprüche**

1. Verfahren zum Herstellen von hochintegrierten komplementären MOS-Feldeffekttransistorschaltungen (CMOS-Schaltungen), bei dem für die Aufnahme der n- bzw. p-Kanaltransistoren der Schaltung im Halbleitersubstrat p- bzw. n-dotierte Wannen erzeugt werden, in welche zur Einstellung der verschiedenen Transistoreinsatzspannungen die entsprechenden Dotierstoffatome durch mehrfache Ionenimplantationen eingebracht werden, wobei die Maskierung für die einzelnen Ionenimplantationen durch Fotolack- oder durch Siliziumoxid- bzw. Siliziumnitrid-Strukturen erfolgt und bei dem die Herstellung der Source/Drain- und Gate-Bereiche sowie die Erzeugung des Zwischen- und Isolationsoxids und der Leiterbahnebene nach bekannten Verfahrensschritten der MOS-Technologie vorgenommen wird, gekennzeichnet durch den Ablauf folgender Verfahrensschritte

a) Herstellung der p-Wanne (5) durch eine Bor-Implantation (4) im n-dotierten Substrat (1, 2) nach erfolgter Maskierung der übrigen Bereiche mit einer Oxidmaske (3),

b) Ablösen der Oxidmaske (3),

c) Herstellung der n-Wanne (8) und Dotierung des p-Kanals durch ganzflächige Phosphor-, Arsen- oder Antimon-Implantation (7),

d) Abscheidung einer Siliziumnitridschicht (9) in einer, der später zu erfolgenden Bor-Implantation (10a, 10b), angepaßten Schichtdicke und Strukturierung so, daß die Bereiche, in denen später die Kanaltransistoren erzeugt werden, von der Nitridschicht (9) bedeckt bleiben,

e) Durchführung einer ersten Fotolacktechnik (13), wobei alle Bereiche außer den p-Wannenbereichen (5) mit Fotolack (13) bedeckt bleiben,

f) Durchführung einer doppelten Bor-Implantation (10a, 10b), wobei zur Dotierung der Feldbereiche (11) eine erste Bor-Implantation (10a) mit niedriger Energie durchgeführt wird, die von der Silizium-Nitrid-Schicht (9) maskiert wird, und zur Dotierung des n-Kanals (12) eine zweite Bor-Implantation (10b) mit höherer Energie durchgeführt wird, die von der Siliziumnitridschicht (9) nicht maskiert wird,

g) Durchführung einer zweiten Fotolacktechnik (14) nach Entfernen der ersten Fotolackstruktur (13), wobei alle Bereiche außer den n-Wannenbereichen (8) mit Fotolack (14) bedeckt bleiben,

h) Durchführung einer Arsen-Implantation (13) zur Dotierung der Feldbereiche (16) der p-Kanaltransistoren,

i) Ablösen der Fotolackstrukturen (14),

k) Erzeugen der Feldoxidbereiche (17) mittels lokaler Oxidation unter Verwendung der Siliziumnitridschicht (9) als Maskierung und

l) Ablösen der Siliziumnitridmaske (9).

2. Verfahren nach Anspruch 1, dadurch gekennzeichnet, daß vor der ganzflächigen n-Implantation (7) zur Herstellung der n-Wanne (8) und zur Dotierung des p-Kanals nach Verfahrensschritt c) eine ganzflächige Oxidschicht (6) auf der Substratoberfläche erzeugt wird.

3. Verfahren nach Anspruch 1 und/oder 2, dadurch gekennzeichnet, daß als Substrat (1) n-dotiertes, in (100)-Richtung orientiertes Silizium von 10 bis 30 Ohm/cm oder eine solche epitaxiale Schicht (2) auf einem n+-dotierten Siliziumsubstrat (1) verwendet wird.

4. Verfahren nach Anspruch 1 bis 2, dadurch gekennzeichnet, daß beim Verfahrensschritt c) die Dosis und Energie der Phosphor-, Arsen- oder Antimon-Implantation (7) auf einen Bereich von 5. $10^{10}$ bis 5 . $10^{11}$ cm$^{-2}$ und 23 bis 200 keV eingestellt wird.

5. Verfahren nach Anspruch 1 bis 5, dadurch gekennzeichnet, daß die Dicke der Siliziumnitridschicht (9) gemäß Verfahrensschritt d) auf einen Wert im Bereich von 60 bis 180 nm eingestellt wird.

6. Verfahren nach Anspruch 1 bis 5, dadurch gekennzeichnet, daß die Dosis und Energie für die erste Borimplantation (10a) auf einen Bereich von 3 . $10^{12}$ bis 5 . $10^{13}$ cm$^{-2}$ und 10 bis 35 keV und für die zweite Borimplantation (10b) auf einen Bereich von 1 . $10^{11}$ bis 2 . $10^{12}$ cm$^{-2}$ und 50 bis 150 keV eingestellt wird.

7. Verfahren nach Anspruch 5 und 6, dadurch gekennzeichnet, daß bei einer Schichtdicke der Siliziumnitridschicht (9) von 120 nm die Dosis und Energie der ersten Borimplantation (10a) auf 1 . $10^{13}$ cm$^{-2}$ und 25 keV und die der zweiten Borimplantation (10b) auf 8 . $10^{11}$ cm$^{-2}$ und 80 keV eingestellt wird.

8. Verfahren nach Anspruch 1 bis 7, dadurch gekennzeichnet, daß die Dosis und Energie für die Arsen-Implantation (15) gemäß Verfahrensschritt h) auf einen Bereich von 5 . $10^{11}$ bis 1 . $10^{13}$ cm$^{-2}$ und 60 - 180 keV eingestellt wird.


**Claims**

1. A method for the production of highly-integrated, complementary MOS-field effect transistor circuits (CMOS-circuits), in which to accommodate the n- and p-channel transistors of the circuit, p- and n-doped troughs are produced in the semiconductor substrate, into which, in order to set the various transistor threshold voltages, the corresponding dopant atoms are introduced by multiple ion implantation steps, the masking for the individual ion implantation steps being effected by photo-resist structures or by silicon oxide or silicon nitride structures, and the production of the source/drain and gate regions and production of the intermediate oxide and insulating oxide and of the conductor path level are carried out in accordance with known process steps in MOS-technology, characterised by the sequence of the following process steps:

a) production of the p-trough (5) by boron implantation (4) in the n-doped substrate (1, 2), after the masking of the other zones with an oxide mask (3),

b) removal of the oxide mask (3),

c) formation of the n-trough (8) and doping of the p-channel by the implantation (7) of phosphorus, arsenic, or antimony, over the entire surface,

d) deposition of a silicon nitride layer (9) in a layer thickness adapted to the boron implantation (10a, 10b) which is to be subsequently carried out, and structuring in such a manner that those zones in which the channel transistors are later to be produced remain covered by the nitride layer (9),

e) carrying out of a first photo-resist process (13), in which all zones, other than the p-trough zones (5), remain covered by photo-resist (13),

f) carrying out of a double boron implantation (10a, 10b), where, for the doping of the field zones (11), a first boron implantation (10a) is carried out at a low energy and is masked by the silicon nitride layer (9), and for the doping of the n-channel (12), a second boron implantation (10b) is carried out at a higher energy and is not masked by the silicon nitride layer (9),

g) carrying out of a second photo-resist process (14) after removal of the first photo-resist structure (13), in which all zones, other than the n-trough zones (8), remain covered by photo-resist (14),

h) carrying out of an arsenic implantation step (15) for the doping of the field zones (16) of the p-channel transistors,

i) removal of the photo-resist structures (14),

k) formation of the field oxide zones (17) by local oxidation using the silicon nitride layer (9) as mask,

l) removal of the silicon nitride mask (9).

2. A method as claimed in claim 1, characterised in that prior to the n-implantation (7) over the entire surface for the production of the n-trough (8) and the doping of the p-channel in accordance with process step (c), an oxide layer (6) is produced on the whole of the substrate surface.

3. A method as claimed in claim 1 and/or claim 2, characterised in that the substrate (1) consists of n-doped silicon of 10 to 50 Ohm/cm, orientated in the (100) direction, or of such an epitaxial layer (2) on an n+-doped silicon substrate (1).

4. A process as claimed in claim 1 to 3, characterised in that in process step (c), the dose and energy of the phosphorus, arsenic or antimony implantation (7) are set in ranges of $5.10^{10}$ to $5.10^{11}$ cm$^{-2}$ and 25 to 200 keV respectively.

5. A process as claimed in claim 1 to 4, characterised in that the thickness of the silicon nitride layer (9) in accordance with process step (d) is set at a value in the range of 60 to 180 nm.

6. A process as claimed in claim 1 to 5, characterised in that the dose and energy for the first boron implantation (10a) are set in ranges of $3.10^{12}$ to $5.10^{13}$ cm$^{-2}$ and 10 to 35 keV respectively and for the second boron implantation (10b) in ranges of $1.10^{11}$ to $2.10^{12}$ cm$^{-2}$ and 50 to 150 keV respectively.

7. A process as claimed in claim 5 and 6, characterised in that, where the silicon nitride layer (9) has a layer thickness of 120 nm, the dose and energy of the first boron implantation (10a) are set at $1.10^{13}$ cm$^{-2}$ and 25 keV respectively and for the second boron implantation (10b), at $8.10^{11}$ cm$^{-2}$ and 80 keV respectively.

8. A process as claimed in claim 1 to 7, characterised in that the dose and energy for the arsenic implantation (15) in accordance with process step (h) are set at ranges of $5.10^{11}$ to $1.10^{13}$ cm$^{-2}$ and 60 to 180 keV respectively.

**Revendications**

1. Procédé pour fabriquer des circuits à transistors à effet de champ MOS complémentaires à haute densité d'intégration (circuits CMOS), selon lequel, pour loger les transistors à canal n ou p du circuit, on aménage, dans le substrat semiconducteur, des cuvettes dopées du type p ou n, dans lesquelles, pour régler les différentes tensions de déclenchement des transistors, on insère les atomes correspondants de substance dopante au moyen d'implantations ioniques multiples, auquel cas le masquage pour les différentes implantations ioniques est réalisé par des structures formées d'une laque photosensible ou de structures d'oxyde de silicium ou de nitrure de silicium, et selon lequel la fabrication des régions de source/drain et de grille ainsi que la production de l'oxyde intermédiaire et de l'oxyde d'isolation et des plans des voies conductrices est réalisée conformément aux étapes opératoires connues de la technologie MOS, caractérisé par l'exécution des phases opératoires suivantes:

a) fabrication de la cuvette de type p (5) au moyen d'une implantation de bore (15) dans le substrat (1, 2) dopé de type n, après l'exécution du masquage des autres zones par un masque d'oxyde (3),

b) élimination par dissolution du masque d'oxyde (3),

c) fabrication de la cuvette (8) de type n et dopage du canal de type p au moyen d'une implantation (7) de phosphore d'arsenic ou d'antimoine sur toute la surface,

d) dépôt d'une couche de nitrure de silicium (9) avec une épaisseur de couche adaptée à l'implantation de bore (10a, 10b) devant être réalisée ultérieurement, et structuration de telle sorte que les zones, dans lesquelles les transistors à canal sont réalisés ultérieurement, restent recouvertes par la couche de nitrure (9),

e) mise en oeuvre d'une première technique (13) utilisant une laque photosensible, auquel cas toutes les zones situées en dehors des zones (5) des cuvettes de type p restent recouvertes par la laque photosensible (13),

f) exécution d'une double implantation de bore (10a, 10b) auquel cas pour le dopage des zones de champ (11), on réalise une première implantation de bore (10a) avec une faible énergie, cette implantation étant bloquée par un masque formé par la couche de nitrure de silicium (9), et pour le dopage du canal n (12) on réalise une seconde implantation de bore (10b) avec une énergie supérieure, l'implantation n'étant pas bloquée par le masque formé par la couche de nitrure de silicium (9),

g) mise en oeuvre d'une seconde technique (14) utilisant une laque photosensible après élimination de la première structure (13) formée d'une laque photosensible, auquel cas toutes les zones situées en dehors des zones (8) des cuvettes de type n restent recouvertes par la laque photosensible (14),

h) exécution d'une implantation d'arsenic (15) pour réaliser le dopage des zones de champ (16) des transistors à canal p,

i) élimination par dissolution des structures (14) formées de la laque photosensible,

k) production des zones d'oxyde de champ (17) au moyen d'une oxydation locale moyennant l'utilisation de la couche de nitrure de silicium (9) en tant que masque, et

l) élimination par dissolution du masque de nitrure de silicium (9).

2. Procédé suivant la revendication 1, caractérisé par le fait qu'avant l'implantation de type n (7) réalisée sur toute la surface pour fabriquer la cuvette (8) de type n et pour doper le canal de type p conformément à la phase opératoire c), on réalise une couche d'oxyde (6) s'étendant sur toute la surface supérieure du substrat.

3. Procédé suivant la revendication 1 et/ou 2, caractérisé par le fait qu'on utilise comme substrat (1), du silicium dopé du type n orienté selon la direction (100) présentant une valeur de 10 à 50 ohms/cm ou une telle couche épitaxiale (2) sur un substrat en silicium (1) dopé du type $n^+$.

4. Procédé suivant les revendications 1 à 3, caractérisé par le fait que lors de la phase opératoire c), la dose et l'énergie de l'implantation de phosphore, d'arsenic ou d'antimoine (16) sont réglées dans des gammes respectives de $5.10^{10}$ à $5.10^{11}$ $cm^{-2}$ et de 25 à 200 keV.

5. Procédé suivant les revendications 1 à 4, caractérisé par le fait que l'épaisseur de la couche de niture de silicium (9) pour la phase opératoire d) est réglée à une valeur située dans la gamme comprise entre 60 et 180 nm.

6. Procédé suivant les revendications 1 à 5, caractérisé par le fait que la dose et l'énergie pour la première implantation de bore (10a) sont réglées respectivement dans des gammes de $3.10^{12}$ à $5.10^{13}$ $cm^{-2}$ et de 10 à 35 keV et, pour la seconde implantation de bore (10b), dans des gammes respectives de $1.10^{11}$ à $2.10^{12}$ $cm^{-2}$ et de 50 à 150 keV.

7. Procédé suivant les revendications 5 et 6, caractérisé par le fait que, pour une épaisseur de la couche de nitrure de silicium (9) de 120 nm, la dose et l'énergie de la première implantation de bore 10a sont réglées respectivement à $1.10^{13}$ $cm^{-2}$ et 25 keV, et la dosée et l'énergie de la seconde implantation de bore (10b) sont réglées respectivement à $8.10^{11}$ $cm^{-2}$ et 80 keV.

8. Procédé suivant les revendications 1 à 7, caractérisé par le fait que la dose et l'énergie pour l'implantation de l'arsenic (15) lors de la phase opératoire h) sont réglées dans des gammes respectives allant de $5.10^{11}$ à $1.10^{13}$ $cm^{-2}$ et de 60 à 180 keV.

## FIG 1

## FIG 2

## FIG 3

# FIG 4

# FIG 5

# FIG 6